# EUROPÄISCHE PATENTSCHRIFT

(11) **EP 1 805 353 B1**
(45) Veröffentlichungstag und Bekanntmachung des Hinweises auf die Patenterteilung: **18.01.2012**
(21) Anmeldenummer: 05797151.7
(22) Anmeldetag: 17.10.2005
(51) Int. Cl.: C30B 23/00, C30B 23/02

(54) **VERFAHREN ZUR HERSTELLUNG VON GAN- ODER ALGAN-KRISTALLEN**
METHOD FOR PRODUCING GAN OR ALGAN CRYSTALS
PROCEDE POUR PRODUIRE DES CRISTAUX DE GAN OU D'ALGAN

(30) Priorität: 16.10.2004 DE 102004050806
(43) Veröffentlichungstag der Anmeldung: 11.07.2007
(73) Patentinhaber: Azzurro Semiconductors AG, 39106 Magdeburg (DE)
(72) Erfinder: DADGAR, Armin, 10555 Berlin (DE); KROST, Alois, 13587 Berlin (DE)
(74) Vertreter: Eckey, Ludger
(86) Internationale Anmeldenummer: PCT/EP2005/055320
(87) Internationale Veröffentlichungsnummer: WO 2006/040359

(56) Entgegenhaltungen:
- EP-A- 0 937 790
- KAMLER G ET AL: "Bulk GaN single-crystals growth" JOURNAL OF CRYSTAL GROWTH, ELSEVIER, AMSTERDAM, NL, Bd. 212, Nr. 1-2, 2000, Seiten 39-48, XP004196201 ISSN: 0022-0248
- SHIN H ET AL: "High temperature nucleation and growth of GaN crystals from the vapor phase" JOURNAL OF CRYSTAL GROWTH, ELSEVIER, AMSTERDAM, NL, Bd. 241, Nr. 4, Juni 2002 (2002-06), Seiten 404-415, XP004360664 ISSN: 0022-0248

## Beschreibung

Die Erfindung betrifft ein Verfahren und eine Reaktoranordnung zur Herstellung eines Galliumnitridkristalls oder eines Aluminiumgalliumnitridkristalls.

Einkristalle von Gruppe-III-Nitrid-Verbindungen können als hochwertige, versetzungsarme Substrate für die Gruppe-III-Nitrid Halbleiterepitaxie, insbesondere von blauen oder UV Lasern eingesetzt werden. Derzeit sind solche Substrate aber nur eingeschränkt verfügbar und extrem teuer: Die Herstellung ist beschränkt auf kleine Flächen oder bei Pseudosubstraten, welche mittels der Hydridgasphasenepitaxie auf Fremdsubstraten hergestellt werden, prozessbedingt auf wenige Millimeter Dicke. Dies führt dazu, dass versetzungsarme Substrate nur unter großem Aufwand hergestellt werden können und entsprechend teuer sind. Die Züchtung aus einer Schmelze, z. B. analog zum Liquid Encapsulated Czochralski beim GaAs, ist bisher nicht gelungen und wird aufgrund der über einer Schmelze entstehenden sehr hohen Stickstoffdampfdrücke auch nicht in absehbarer Zeit möglich sein.

Einkristalle aus AIN werden dagegen zur Zeit hauptsächlich mittels Sublimationstechniken bei sehr hohen Drücken hergestellt. Dazu wird AIN-Pulver erhitzt, sublimiert und diffundiert zum kälteren Ende der Wachstumskammer wo dann ein AIN-Kristall wächst. Nachteile sind hier die schwierige Skalierbarkeit, die hohe Verunreinigung des Einkristalls und die immer noch sehr kleinen Kristalle, die für die Epitaxie nur eingeschränkt nutzbar sind. Das direkte Wachstum aus Aluminiumdampf und NH₃ ist z. B. schon von Witzke, H.-D.: Über das Wachstum von AIN Einkristallen, Phys. Stat. sol. 2, 1109 (1962), und Pasternak J. und Roskovcová L.: Wachstum von AlN Einkristallen, Phys. Stat. sol. 7, 331 (1964), beschrieben. Hier wurde eine Vielzahl von kleinen Einkristallen gewachsen, die für materialwissenschaftliche Grundlagenuntersuchungen, nicht jedoch für die Epitaxie von Bauelementen geeignet sind. Für die Gruppe-III-Nitrid-Epitaxie von Halbleiterlasern sind vor allen Dingen GaN Substrate notwendig, bei denen ein analoges Verfahren nicht einfach möglich ist, da es zu einer störenden Ausbildung von GaN auf der Galliumschmelze kommt, wie z.B. von Balkas, C. M. et al.: Growth and Characterization of GaN Single Crystals, Journal of Crystal Growth 208, 100 (2000), Elwell, D. et al.: Crystal Growth of GaN by the Reaction between Gallium and Ammonia, Journal of Crystal Growth 66, 45 (1984), oder Ejder, E.: Growth and Morphology of GaN, Journal of Crystal Growth 22, 44 (1974), beschrieben. Bei Elwell et al. ist insbesondere von einer immer beobachteten Oberflächenreaktion zwischen metallischem Gallium und Ammoniak die Rede, die dazu führt, dass auf der Galliumschmelze und auch an von Gallium bedeckten Reaktorteilen kleine Kristalle wachsen.

Aktuell werden für das Wachstum von Halbleiterlasern auf GaN sogenannte Pseudosubstrate mittels Hydridgasphasenepitaxietechniken hergestellt wie z. B. bei einem der größten Hersteller solcher Substrate, Sumitomo in Japan, vgl. JP002004111865AA. Hier reagiert das Galliummetall in einem vom Stickstoffprecursor Ammoniak getrennten Bereich durch das Überleiten von Chlor zu Galliumchlorid, was dann wiederum über einem Substrat mit Ammoniak zu GaN und Ammoniumchlorid reagiert. Letztere Verbindung ist beim Kristallwachstum überaus problematisch, da sie in großen Mengen anfällt und als Feststoff die Reaktionskammer und das Abgassystem belegen bzw. verstopfen kann sowie oft das Kristallwachstum durch eine starke Partikelbildung stört.

Alternativ werden GaN-Plättchen bei hohen Drücken und Temperaturen aus einer Galliumschmelze hergestellt, vgl. US6273948B1 und Grzegory, I. et al.: Mechanisms of Crystallization of Bulk GaN from the Solution under high N2 Pressure, Journal of Crystal Growth 246, 177 (2002). Hier sind jedoch bislang keine für die kommerzielle Verwertung ausreichenden Größen erzielt worden und die Kristalle weisen teilweise hohe Sauerstoffkonzentrationen auf, was sie zwar hochleitfähig, aber auch, im Vergleich hochreinem epitaktischem GaN, gitterfehlangepasst macht. Auch die Herstellung von GaN-Einkristallen direkt aus bzw. in Metallschmelzen (US 6592663B1), zum Teil mit dem Ergebnis relativ großer aber dünner Einkristalle, ist bekannt, hat sich bislang aber wahrscheinlich aufgrund der berichteten hohen Kohlenstoffeinlagerungen (vgl. Soukhoveev, V. et al.: Characterization of 2.5-Inch Diameter Bulk GaN Grown from Melt-Solution, phys.stat.sol.(a) 188, 411 (2001)) und der geringen Schichtdicke nicht durchsetzen können.

Erstaunlich ist dabei der geringe Fortschritt im über 40-jährigen Studium der Herstellung von GaN-Einkristallen. Die meisten Arbeiten beschäftigen sich dabei, wie schon erwähnt, mit der Herstellung der Kristalle aus Schmelzen oder aus der Gasphase durch die Reaktion von Galliumchlorid und Ammoniak. Wenige Arbeiten beschäftigen sich mit der Reaktion von geschmolzenem Gallium und einem reaktivem Stickstoffprecursor wie z. B. Ammoniak, und dann immer bei direktem Kontakt der Stoffe an der Schmelze wie zum Beispiel in den Arbeiten von Shin, H. et al.: High temperature nucleation and growth of GaN crystals from the vapor phase, Journal of Crystal Growth 241, 404 (2002); Balkas, C. M. et al: Growth and Characterization of GaN Single Crystals, Journal of Crystal Growth 208, 100 (2000); Elwell, D. et al.: Crystal Growth of GaN by the Reaction between Gallium and Ammonia, Journal of Crystal Growth 66, 45 (1984); oder von Ejder, E.: Growth and Morphology of GaN, Journal of Crystal Growth 22, 44 (1974). Bei Shin wird beschrieben, dass sich eine Kruste auf der Galliumschmelze bildet welche das Kristallwachstum durch eine dadurch hervorgerufene Tröpfchenbildung des Gallium auf umliegenden Wänden stört. Insbesondere werden bei diesen Methoden immer eine Vielzahl von kleinen Kristallen in der Reaktionskammer erzeugt und das Kristallwachstum ist zum größten Teil unkontrolliert und daher wenig geeignet für große Einkristalle, jedoch gut für kleine sehr hochwertige Kristalle für Forschungsanwendungen.

Aus der JP 11-209 199 A ist eine Reaktoranordnung zur Herstellung von GaN-Einkristallen mit einem so genannten Hot-Wall-Verfahren bekannt. Ein Nachteil des dort beschriebenen Verfahrens ist für eine großtechnische Anwendung ist eine zu geringe erzielbare Wachstumsrate des Einkristalls.

Das der vorliegenden Erfindung zugrunde liegende technische Problem ist es, ein Verfahren und eine Reaktoranordnung zur Herstellung von Galliumnitridkristallen oder von Aluminiumgalliumnitridkristallen anzugeben, das ein Kristallwachstum durch Reaktion von geschmolzenem Gallium mit einem reaktivem Stickstoffprecursor ohne Krustenbildung auf der Galliumschmelze und die damit verbundenen Probleme beim Kristallwachstum sowie mit verbesserter Wachstumsrate ermöglicht.

Ein erster Aspekt der vorliegenden Erfindung betrifft ein Verfahren zur Herstellung eines Galliumnitridkristalls oder eines Aluminiumgalliumnitridkristalls. Das Verfahren umfasst die Schritte
- Bereitstellen einer Metallschmelze aus reinem Gallium oder aus einer Mischung von Aluminium und Gallium in einem Schmelztiegel;
- Verdampfen von Gallium oder von Gallium und Aluminium aus der Metallschmelze;
- Zerlegen eines Stickstoffprecursors durch thermische Einwirkung oder mittels eines Plasmas;
- Herbeiführen einkristallinen Kristallwachstums eines GaN- oder AIGaN-Kristalls an einem Keimkristall unter einem Druck von weniger als 10 bar.

Das Verdampfen von Gallium oder von Gallium und Aluminium wird bei einer Temperatur oberhalb der Temperatur des wachsenden Kristalls, mindestens aber bei 1000 °C durchgeführt.

Bei dem erfindungsgemäßen Verfahren wird ein Gasstrom aus Stickstoffgas, Wasserstoffgas, Inertgas oder einer Kombination dieser Gase über die Metallschmelzenoberfläche geleitet, derart, dass der Gasstrom über die Metallschmelzenoberfläche einen Kontakt des Stickstoffprecursors mit der Metallschmelze verhindert.

Das erfindungsgemäße Verfahren bildet eine Alternative zum Wachstum von Galliumnitrid oder Aluminiumgalliumnitrid durch Flüssigphasen-Hydridepitaxieverfahren oder die simple Reaktion von Galliumdampf und Ammoniak. Bei dem erfindungsgemäßen Verfahren wird reines Metall verdampft und in einem Gasstrom in einen Reaktionsbereich transportiert, wo ein einkristallines Kristallwachstum eines GaN- oder AIGaN-Kristalls an einem Keimkristall herbeigeführt wird. Das Problem des geringen Dampfdrucks von Gallium wird bei dem erfindungsgemäßen Verfahren dadurch behoben, dass eine für sinnvolle Wachstumsraten des Kristalls geeignete Temperatur von mindestens 1000 °C für das Verdampfen von Gallium oder von Gallium und Aluminium eingestellt wird.

Ferner löst das erfindungsgemäße Verfahren das Problem der häufig beobachten direkten Reaktion von Gallium mit dem Stickstoffprecursor, indem über die Metallschmelzenoberfläche ein Gasstrom aus Stickstoffgas, Wasserstoffgas, Inertgas oder einer Kombination dieser Gase geleitet wird, und zwar der Art, dass der Gasstrom über die Metallschmelzenoberfläche einen Kontakt des Stickstoffprecursors mit der Metallschmelze verhindert. Dabei können je nach verwendetem Gas unterschiedliche Wirkungsmechanismen eingesetzt werden. Ein Inertgas wie zum Beispiel Helium, Argon oder Stickstoff (N₂) kann bei geeigneter Führung und Strömungsgeschwindigkeit des Gasstromes den Kontakt zwischen Schmelze und Stickstoffprecursor verhindern. Je nach Reaktordruck und verwendeten Strömungsgeschwindigkeiten kann andererseits bei Verwendung von Wasserstoffgas eine sich bildende kristalline GaN- oder AIGaN-Schicht auf der Schmelze aufgrund der bei der hohen Temperatur der Schmelze gegebenen hohen Reaktivität des Wasserstoffs zersetzt werden, womit das weitere Verdampfen des Metalls sichergestellt wird.

Stickstoffgas wird hier getrennt von den Inertgasen genannt, obwohl es an sich Eigenschaften eines Inertgases aufweist, nämlich, keine chemische Reaktion mit dem Metall der Schmelze (oder mit dem Stickstoffprecursor) einzugehen. Dies gilt jedoch nur bei niedrigeren Temperaturen, bei denen Stickstoff in molekularer Form (N₂) vorliegt. Bei vom erfindungsgemäßen Verfahren ebenfalls umfassten Temperaturen der Metallschmelze von beispielsweise 1400°C liegt Stickstoff in atomarer Form vor und kann grundsätzlich mit Gallium reagieren, bildet also kein Inertgas. Bei derart hohen Temperaturen kann jedoch trotzdem atomarer Stickstoff über die Metallschmelze geleitet werden, ohne eine Krustenbildung in Kauf nehmen zu müssen, weil GaN in diesem Temperaturbereich nicht stabil ist.

Es ist auch eine Kombination der beiden genannten Wirkungsmechanismen möglich, indem ein Gasstrom über die Metallschmelzenoberfläche geleitet wird, der sowohl Wasserstoffgas als auch ein Inertgas enthält, oder indem mehrere Gasströme über die Metallschmelzenoberfläche geleitet werden, wobei ein Gasstrom durch Intertgas und ein anderer Gasstrom durch Wasserstoff enthaltendes oder aus Wassstoff bestehendes Gas gebildet wird.

Bei dem erfindungsgemäßen Verfahren wird ein gleichmäßiges Wachstum eines Einkristalls auf großer Fläche gefördert, indem das Wachstum auf einem Keimkristall beginnt. Auf diese Weise ermöglicht das erfindungsgemäße Verfahren die Herstellung von Galliumnitrid- oder Aluminiumgalliumnitrid-Substraten.

Der Keimkristall kann alternativ aber auch auf einer kleinen Fläche ausgelegt sein. Dann wächst zunächst ein GaN-Stab. Dies ist für eine Reduktion anfangs unvermeidlich hoher Versetzungsdichten hilfreich. Durch eine geschickte Wahl der Gaszusammensetzung, insbesondere des V/III-Verhältnisses, und des Drucks kann dann ein laterales Wachstum auf einem gewünschten Durchmesser gefördert und schließlich ein langer GaN-Stab mit auch für die Substratherstellung ausreichendem Durchmesser gewachsen werden.

Gegenüber dem bekannten Hydrid-Epitaxieverfahren hat das erfindungsgemäße Verfahren den Vorteil, keine störenden Ablagerungen zu produzieren. Bei der Hydrid-Epitaxie bewirkt beispielsweise die Verwendung von Galliumchlorid und Ammoniak die Entstehung von Ammoniumchlorid-Ablagerungen, die das Wachstum großer Kristalle behindern.

Im Ergebnis bietet die beschriebene Methode sich daher in idealer Weise zur Massenherstellung großer Einkristalle an, aus denen später durch Sägen und Polieren Substrate für die Epitaxie von Gruppe-III-Nitriden hergestellt werden können. Außerdem minimiert das erfindungsgemäße Verfahren aufgrund der erzielbaren Kristallgröße einen Reaktorverschleiß, wie er in der Hydridgasphasenepitaxie in Quarzglasreaktoren die Regel ist. Denn in der Hydridgasphasenepitaxie reißt die aufwachsende Schicht spätestens beim Abkühlen das verwendete Quarzglas ab. Die mit der Hydridgasphasenepitaxie hergestellten Pseudosubstrate sind daher sehr teuer in der Herstellung. Dagegen lassen sich mit dem hier beschriebenen Verfahren aus einem Kristall eine Vielzahl von Substraten sägen, auch wenn ein innerer, belegter Teil des Reaktors zerspringt. Auf diese Weise kann der Preis pro Substrat deutlich verringert werden.

Das erfindungsgemäße Verfahren ist in der Kristallgröße allein durch die Temperaturhomogenität am Ort des Kristallwachstums und durch die Menge geschmolzenen Galliums begrenzt. Gallium kann, da ab 27 °C flüssig, jedoch durch eine Zuführung während des Betriebs, also bei der Kristallherstellung, nachgefüllt werden.

Nachfolgend werden Ausführungsbeispiele des erfindungsgemäßen Verfahrens beschrieben.

Eine Ausführungsform des erfindungsgemäßen Verfahrens sieht vor, dass die Metallschmelze in einem Schmelztiegelgefäß bereitgestellt wird, das, abgesehen von mindestens einer Trägergaszuführung und mindestens einer Trägergasaustrittsöffnung, allseitig geschlossen ist. Bei dieser Ausführungsform wird der Gasstrom durch die Trägergaszuführung oberhalb der Metallschmelze in das Schmelztiegelgefäß eingeleitet und mit Metalldampf der Metallschmelze durch die Trägergasaustrittsöffnung aus dem Schmelztiegelgefäß heraustransportiert.

Diese Ausführungsform bietet einen erhöhten Schutz vor Krustenbildung auf der Oberfläche der Metallschmelze, in Ergänzung zum Gasstrom, indem das Schmelztiegelgefäß bis auf die beschriebenen Gaszu- und -abführungen allseitig geschlossen ist. Es wird auf diese Weise durch die Bauform des Tiegels sichergestellt, dass eine Reaktion des geschmolzenen Metalls nicht auf der Metallschmelzenoberfläche, sondern nur im hierfür vorgesehenen Reaktionsbereich nahe dem Keimkristall oder dem wachsenden Einkristall stattfindet. Darüber hinaus werden durch die geschlossene Bauform des Schmelztiegels günstige Strömungsverhältnisse für den Transport der aus der Metallschmelze verdampfenden Metallatome zum wachsenden Kristall hin geschaffen.

Bei einer alternativen Ausführungsform umfasst das Bereitstellen der Metallschmelze das Anordnen des Schmelztiegels in einer Reaktorkammer, wobei hier mindestens eine Trägergaszuführung in die Reaktorkammer vorgesehen ist. Bei diesem Ausführungsbeispiel wird der Gasstrom durch die Trägergaszuführung geringfügig oberhalb der Metallschmelze in die Reaktorkammer eingeleitet. Der Stickstoffprecursor wird durch die Precursoreintrittsöffnung in einem Reaktionsbereich in die Reaktorkammer eingeleitet. Dieses Ausführungsbeispiel verzichtet im Vergleich mit dem vorangegangenen weitgehend auf eine Abdeckung der Oberfläche der Metallschmelze durch die Bauform des Schmelztiegels, sowie auf die Trägergaszuführung in den Schmelztiegel hinein. Der Schmelztiegel kann daher in besonders einfacher und kostengünstiger Weise hergestellt werden.

Bei beiden alternativen Verfahrensführungen kann der Gasstrom entweder in einer Richtung parallel zur Oberfläche der Metallschmelze oder in einer Richtung senkrecht zur Oberfläche der Metallschmelze in das Schmelztiegelgefäß oder in die Reaktorkammer eingeleitet werden.

Bei einer weiteren bevorzugten Ausführungsform des Verfahrens wird das Verdampfen von Gallium oder von Gallium und Aluminium bei einer Temperatur von mindestens 1100 °C durchgeführt wird. Der dadurch erhöhte Metaildampfdruck kann zur Beschleunigung des Kristallwachstums eingesetzt werden.

Zum gezielten Dotieren der wachsenden Einkristalle können verschiedene Stoffe in die Reaktorkammer eingebracht werden. Dies kann in einer ersten Alternative durch das Einleiten eines gasförmigen Precursors geschehen. Für eine n-Typ-Dotierung können Silizium- oder Germaniumhydridverbindungen, wie zum Beispiel Silan, German, Disilan oder Digerman verwendet werden. Geeignet zur Dotierung sind auch metallorganische Verbindungen wie zum Beispiel Tertiär-Butylsilan. Entsprechendes gilt für die p-Dotierung. Hier ist vornehmlich Magnesium geeignet, welches sehr einfach, zum Beispiel als metallorganisches Zyclopentadienylmagnesium mit einem Trägergas in die Reaktionskammer geleitet werden kann. Für die Herstellung hochohmiger Kristalle bieten sich zum Beispiel Eisen in Form von Zyclopentadienyleisen, auch als Ferozen bekannt, oder andere Übergangsmetalle an, die tiefe Störstellen niveaus möglichst in der Mitte der Bandlücke des entstehenden Halbleiterkristalls erzeugen.

Eine zweite alternative Verfahrensführung zur Dotierung sieht vor, einen Dotierstoff, wie zum Beispiel Silizium, Germanium, Magnesium oder Eisen als reine Schmelze zu verdampfen, oder den jeweiligen Feststoff zu sublimieren. Hierfür ist eine weiter Temperaturzone oder ein getrennt geheizter Tiegel im Reaktor erforderlich. Auch dieser Tiegel muss in den meisten Fällen, analog zur galliumhaltigen Schmelze ebenfalls gegen ein Nitridieren geschützt werden, was ganz analog zur Verfahrensführung am Schmelztiegel des Gruppe-III-Metalls durch einen Gasstrom bewirkt werden kann.

Ein Ausführungsbeispiel, bei der der Gasstrom Wasserstoff enthält oder aus Wasserstoff besteht, sieht vorzugsweise das Bereitstellen der Metallschmelze in einem Schmelztiegel das Verwenden eines Schmelztiegels aus Bornitrid BN, Tantalcarbid TaC, Siliziumcarbid SiC, Quarzglas oder Kohlenstoff oder einer Kombination zweier oder mehrerer dieser Materialien vor. Ein allein aus Kohlenstoff gefertigter Tiegel zersetzt sich erfahrungsgemäß nach einigen Stunden Betriebs unter Wasserstoffzufuhr. Daher sollte ein Kohlenstofftiegel in diesem Fall mit einem der anderen genannten Materialien beschichtet sein.

Einen zweiten Aspekt der Erfindung bildet eine Reaktoranordnung zur Herstellung eines Galliumnitridkristalls oder eines Galliumaluminiumnitridkristalls. Die erfindungsgemäße Reaktoranordnung enthält
- eine Vorrichtung zum Zuführen eines Stickstoffprecursors in einen Reaktionsbereich einer Reaktorkammer,
- eine Vorrichtung zum Zerlegen des Stickstoffprecursors im Reaktionsbereich durch thermische Einwirkung oder mittels eines Plasmas,
- einen Schmelztiegel zur Aufnahme einer Metallschmelze aus reinem Gallium oder aus einer Mischung von Aluminium und Gallium,
- eine erste Heizvorrichtung, die ausgebildet ist, die Temperatur der Metallschmelze im Schmelztiegel auf einen Wert oberhalb der Temperatur des wachsenden Kristalls, mindestens jedoch auf 1000 °C einzustellen,
- eine Trägergasquelle, die ausgebildet ist, Stickstoffgas, Wasserstoffgas, Inertgas oder eine Kombination dieser Gase abzugeben, und
- mindestens eine mit der Trägergasquelle verbundene Trägergaszuführung, die angeordnet und ausgebildet ist, einen Gasstrom über die Metallschmelzenoberfläche zu leiten, derart, dass der Gasstrom einen Kontakt des Stickstoffprecursors mit der Metallschmelze verhindert.

Die Vorteile der erfindungsgemäßen Reaktoranordnung ergeben sich unmittelbar aus den oben beschriebenen Vorteilen des erfindungsgemäßen Verfahrens.

Nachfolgend werden bevorzugte Ausführungsbeispiele der Reaktoranordnung beschrieben. Auf eine ausführliche Darstellung wird verzichtet, soweit Ausführungsbeispiele unmittelbar einen Vorrichtungsaspekt einer oben schon ausführlich beschriebenen Ausführungsform des Verfahrens nach dem ersten Aspekt darstellen.

Bei einer Ausführungsform der erfindungsgemäßen Reaktoranordnung ist der Schmelztiegel als Schmelztiegelgefäß ausgebildet ist, das, abgesehen von der Trägergaszuführung und mindestens einer Trägergasaustrittsöffnung, allseitig geschlossen ist. Die Trägergaszuführung ist oberhalb der Metalischmelzenoberfläche angeordnet.

Die erste Heizvorrichtung ist in einer Variante dieses Ausführungsbeispiels ausgebildet, die Wandungen des Schmelztiegelgefäßes oberhalb der Metallschmelze auf einen höhere Temperatur zu heizen als im Bereich Metallschmelze. Auf diese Weise wird verhindert, dass sich im aufsteigenden Metalldampf Tröpfchen bilden, die sich noch im Schmelztiegel oder an den Wandungen der Reaktorkammer außerhalb des Schmelztiegels niederschlagen können.

Anstelle einer Heizvorrichtung, die unterschiedliche Temperaturbereiche erzeugt, können auch zwei Heizvorrichtungen vorgesehen sein. In dieser Ausführungsform ist kann Trägergasaustrittsöffnung das Ende eines rohrförmigen Auslasses bilden. Eine zweite Heizvorrichtung ist dann ausgebildet, die Wandungen des rohrförmigen Auslasses auf eine höhere Temperatur zu heizen als die erste Heizvorrichtung die Wandungen des Schmelztiegelgefäßes im Bereich der Metallschmelze.

Die Trägergaszuführung ist in unterschiedlichen Ausführungsformen ausgebildet, einen Gasstrom in einer Richtung parallel zur Oberfläche der Metallschmelze oder senkrecht zur Oberfläche der Metallschmelze in das Schmelztiegelgefäß oder die Reaktorkammer einzuleiten. Es ist auch möglich, mehrere Zuführungen vorzusehen, von denen eine eine Einleitung senkrecht zur Schmelzenoberfläche und eine andere eine Einleitung parallel zur Schmelzenoberfläche bereitstellt.

Verschiedene Varianten der Trägergaszuführung werden unten anhand der Figuren näher erläutert.

Bevorzugt ist, insbesondere für die Verwendung von Wasserstoffgas, der Schmelztiegel aus Bornitrid BN, Tantalcarbid TaC, Siliziumcarbid SiC, Quarzglas oder Kohlenstoff, oder aus einer Kombination zweier oder mehrerer dieser Materialien gefertigt.

Für das Wachstum von GaAI-Kristallen kann wie beschrieben ein Schmelztiegel für eine entsprechenden Metallmischung vorgesehen sein. Alternativ können auch zwei separate Schmelztiegel in der Reaktorkammer angeordnet sein, von denen einer eine Galliumschmelze und der andere eine Aluminiumschmelze enthält. Das Verhältnis der beiden Metalle im wachsenden Kristall kann bei dieser Ausführungsform durch die getrennte Einstellung der beiden Schmelztiegeltemperaturen und durch den jeweiligen Trägergasfluss die beiden Tiegel eingestellt werden.

Weitere Ausführungsbeispiele des erfindungsgemäßen Verfahrens und der erfindungsgemäßen Reaktoranordnung werden nachfolgend anhand der beiliegenden Figuren erläutert. Es zeigen:
- Figur 1: ein erstes Ausführungsbeispiel einer Reaktoranordnung in einer schematischen Darstellung,
- Figuren 2 - 8: verschiedene Varianten von Schmelztiegeln zur Verwendung in einer erfindungsgemäßen Reaktoranordnung, und
- Figur 9: ein zweites Ausführungsbeispiel einer Reaktoranordnung zur Herstellung eines GaN- oder AlGaN-Kristalls.

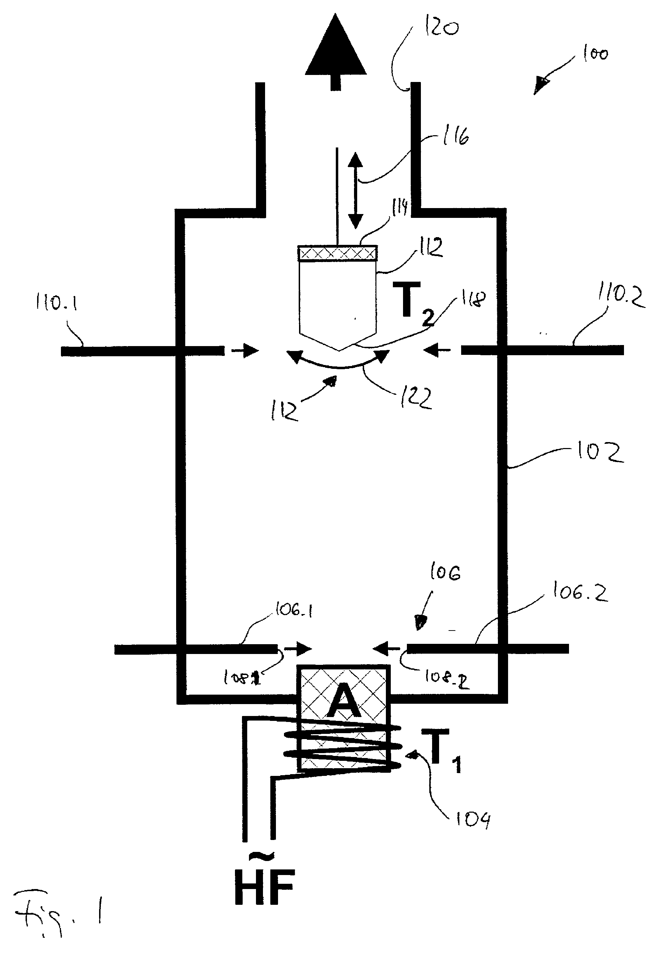

Figur 1 zeigt ein erstes Ausführungsbeispiel einer Reaktoranordnung 100 in einer vereinfachten, schematischen Darstellung. Bei der Reaktoranordnung 100 handelt es sich um einen vertikalen Reaktor. Ein Reaktorgefäß 102 enthält in einem unteren Abschnitt einen Schmelztiegel A, der eine Galliumschmelze (nicht dargestellt) enthält. Eine Hochfrequenzheizung 104 beheizt die Galliumschmelze durch ein hochfrequentes elektrisches Wechselfeld. Eine derartige Hochfrequenzheizung ist für das Erreichen hoher Temperatur bis über 2000 °C ideal geeignet, weil sie wartungsarm und kontaktfrei arbeitet. Knapp oberhalb des Schmelztiegels befindet sich eine Trägergaszuführung 106 in Form von Gasleitungen 106.1 und 106.2, die auf gleicher Höhe und gegenüberliegend, d. h., mit ihren Öffnungen aufeinander zuweisend, angeordnet sind. Austrittsöffnungen 108.1 und 108.2 sind mit geringem seitlichen Abstand vom Schmelztiegel A angeordnet. Da der Schmelztiegel A nach oben hin offen ist, kann durch diese Anordnung der Trägergaszuführung 106 ein Gasstrom erzeugt werden, der unmittelbar über die Oberfläche der Metallschmelze geführt wird.

Der Stickstoffprecursor wird durch Precursorzuleitungen 110.1 und 110.2 in einen Reaktionsbereich 112 eingeleitet, der sich knapp unterhalb eines auf der Grundlage eines ursprünglich vorhandenen Keimkristalls wachsenden Galliumnitridkristalls 112 befindet. Der Galliumnitridkristall ist an einem Halter 114 befestigt, der mit Hilfe einer geeigneten Stellvorrichtung (nicht dargestellt) in vertikalen Richtungen (angedeutet durch den Doppelpfeil 116) kontrolliert verschoben werden kann. Dies erfolgt zum einen zum Einführen des Keimkristalls in die Reaktorkammer und zum anderen zum Halten der aktuellen Wachstumsoberfläche des entstehenden Kristalls auf der selben vertikalen Position.

Bei der Anordnung der Figur 1 bewirkt der durch die Trägergaszuleitungen 106.1 und 106.2 hervorgerufene Gasstrom einen Transport von galliumreichen Dampf aus dem Bereich der Metallschmelze im Schmelztiegel A in Richtung des wachsenden Kristalls 112. Dies ist vor allen Dingen beim Betrieb unter hohem Druck notwendig, da der Galliumdampf sich sonst nur durch Diffusion ausbreitet. Wären die Reaktorwände kälter, würde sich Galliumdampf dort so stark ablagern, dass je nach Abstand zwischen Schmelztiegel A und Kristall 112 der Galliumdampf den Kristall nur in verminderter Menge oder gar nicht erreicht.

Neben den in Figur 1 dargestellten Gaseinlässen 106.1 und 106.2 kann die Trägergaszuführung 106 weitere Gaseinlässe enthalten, durch die im unteren Teil der Reaktorkammer 102 ein weiterer Gasstrom erzeugt wird, der die Gasmischung verändern kann. Das Einleiten von Gas durch die Zuleitungen 106.1 und 106.2 steuert die Zusammensetzung der Gasatmosphäre im Bereich des Schmelztiegels A maßgeblich. Am besten sind die in hoher Reinheit verfügbaren Gase H₂ und N₂ geeignet. Im vorliegenden Beispiel könnte durch weitere Gaseinlässe beispielsweise das Verhältnis von H₂ und N₂ verändert werden, wodurch das Kristallwachstum gezielt beeinflusst werden kann, und zusätzlich auch die Ablagerungen an den Wänden der Reaktorkammer 102 verringert werden können.

Dabei ist es in der vorliegenden Ausführungsform eines vertikalen Reaktors vorteilhaft, dass die Austrittsöffnungen einander gegenüberliegend angeordnet sind. Auf diese Weise wird der Transport des Galliumdampfes nach oben hin verbessert.

Alternativ zur dargestellten Anordnung der Precursorzuleitungen 110.1 und 110.2 können diese auch oberhalb der Wachstumsoberfläche 118 des entstehenden Kristalls 112 angeordnet sein. In diesem Fall diffundiert der Stickstoffprecursor dann gegen den Gasstrom, der zu einem Auslass 120 am oberen Ende der Reaktorkammer führt, zur Wachstumsfront 118 am unteren Kristallende. Durch die vertikale Position der Stickstoffzuführungen 110.1 und 110.2 kann das laterale und vertikale Kristallwachstum in geringem Maße gesteuert werden.

Zum gezielten Dotieren der wachsenden Einkristalle können verschiedene Stoffe in die Reaktorkammer eingebracht werden. Dies kann durch das Einleiten eines gasförmigen Precursors geschehen. Für eine n-Typ-Dotierung können Silizium-oder Germaniumhydridverbindungen, wie zum Beispiel Silan, German, Disilan oder Digerman verwendet werden. Geeignet zur Dotierung sind auch metallorganische Verbindungen wie zum Beispiel Tertiär-Butylsilan können für eine n-Dotierung in die Reaktionskammer geleitet werden. Entsprechendes gilt für die p-Dotierung. Hier ist vornehmlich Magnesium geeignet, welches sehr einfach, zum Beispiel als metallorganisches Cyclopentadienylmagnesium mit einem Trägergas in die Reaktionskammer geleitet werden kann. Für hochohmige Schichten bietet sich zum Beispiel Eisen in Form von Cyclopentadienyleisen, auch als Ferrozen bekannt, oder andere Übergangsmetalle an, die tiefe Störstellenniveaus möglichst in der Mitte der Bandlücke erzeugen. Eine andere Möglichkeit besteht darin, die Dotierstoffe wie zum Beispiel Silizium, Germanium, Magnesium oder Eisen als reine Schmelzen zu verdampfen, oder den jeweiligen Feststoff zu sublimieren. Hierfür ist eine weitere Temperaturzone beziehungsweise ein getrennt geheizter Tiegel im Reaktor erforderlich. Auch dieser Tiegel muss in den meisten Fällen, analog zur galliumhaltigen Schmelze ebenfalls gegen ein Nitridieren geschützt werden.

Der wachsende Kristall 112 beziehungsweise die Reaktorkammer in ihrem oberen Teil werden auf eine Temperatur T₂ geheizt, die bei etwa 1000 °C liegt und zum Beispiel durch das Heizen der Reaktorwandung mit Hilfe eines außen angebrachten Widerstandsheizers (nicht dargestellt) oder einer Lampenheizung (ebenfalls nicht dargestellt) erfolgt. Im unteren Bereich der Reaktorkammer 102 empfiehlt es sich, die Reaktorwandung auf eine ähnliche oder etwas höhere Temperatur wie die Temperatur des Schmelztiegels (T1) zu heizen, um eine zu starke Ablagerung von Gallium an der Reaktorwandung zu verhindern.

Durch die Gaszusammensetzung, also das Verhältnis von beispielsweise von H₂, N₂, sowie dem Stickstoffprecursor, sowie durch die Wachstumstemperatur und den Reaktordruck kann die Wachstumsgeschwindigkeit in verschiedenen Kristallrichtung nach Bedarf gesteigert oder gehemmt werden, so dass gezielte Kristallausrichtungen und Kristallformen erzielt werden können.

Als Keimkristall dient beispielsweise eine dünne GaN-Schicht auf einem Fremdsubstrat. Versetzungen werden im Laufe des Wachstums eines dickeren Kristalls immer weiter abgebaut. Der wachsende Kristall kann zur Steigerung der Homogenität des Wachstums rotiert werden (angedeutet durch Doppelpfeil 122) und sollte mit zunehmender Dicke nach oben gezogen werden, um die Wachstumsbedingungen an der Wachstumsfront 118 am unteren Kristallende immer gleich zu halten.

Sollen sehr lange Kristalle gezogen werden, empfiehlt es sich beim Ziehen des Kristalls nach oben diesen am oberen Ende nicht stark abzukühlen, um Verspannungen zu vermeiden, die zu Versetzungen und Rissen führen können. Dies kann durch eine entsprechend lange Auslegung des Reaktors beziehungsweise des Gasauslasses 120 und durch Heizen der betreffenden Bereich bewerkstelligt werden.

Vorteil der hier in Figur 1 dargestellten hängenden Konstruktion des Kristallhalters 114 ist die Vermeidung von parasitären Depositionen auf dem Kristall 112. Bei anderen Geometrien können herabfallende Ablagerungen, die auf den Reaktorwänden entstehen, derartige parasitäre Depositionen hervorrufen.

Das Material der Reaktorkammer kann beispielsweise Quarzglas sein. Bei Quarzglas reißt jedoch die wachsende Schicht auf der Reaktorwandung das Glas mit ab, was ein vollständiges Zerstören des Reaktors nach sich zieht. Die Ablagerungen können jedoch durch das Einleiten von den Inertgasen oder Wasserstoff entlang der Reaktorwand verringert werden. Bevorzugt gegenüber Quarzglas ist jedoch die Verwendung von Bornitrid (BN) da dieses Material die Entfernung von Ablagerungen ohne eine Zerstörung des Bornitrids ermöglicht.

Auch als Material des Schmelztiegels A bietet sich vor allen Dingen Bornitrid in idealer Weise an, weil es in hoher Reinheit hergestellt werden kann, durch den Stickstoffprecursor stabilisiert wird und als Spurenverunreinigung in den entstehenden GaN- oder AIGaN-Einkristallen nur wenig stört. Alternativ kann jedoch auch jedes andere hochtemperaturresistente Material verwendet werden, welches sich bei den verwendeten Temperaturen und Gasatmosphären nicht zerlegt. Dies sind neben Quarzglas die Materialien Tantalcarbid TaC, Siliziumcarbid SiC und Kohlenstoff C. Bei der Verwendung von Graphit in einer Wasserstoffatmosphäre empfiehlt sich eine Beschichtung mit Siliziumcarbid SiC.

Restgase treten im Ausführungsbeispiel der Figur 1 am oberen Ende des Reaktors aus, wo zur Erzeugung eines Unterdrucks eine Pumpe (nicht dargestellt) oder zur Erzeugung eines Überdrucks ein steuerbares Drosselventil (ebenfalls nicht dargestellt) angebracht sein kann.

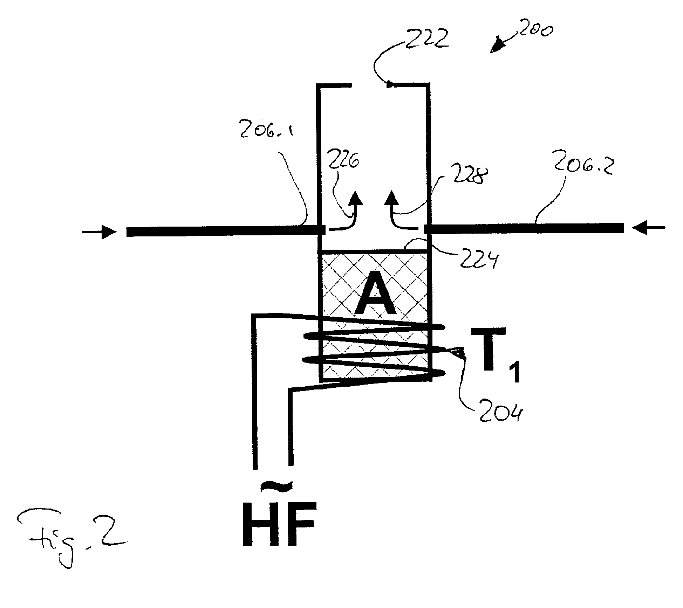

Figur 2 zeigt eine erste Variante eines Schmelztiegels 200 zur Verwendung in der Reaktoranordnung der Figur 1 anstelle des Schmelztiegels A. Der Schmelztiegel 200 ist, abgesehen von Trägergaszuführungen 206.1 und 206.2 und einer Trägergasaustrittsöffnung 222 allseitig geschlossen ausgeführt. Im Unterschied zum Ausführungsbeispiel der Figur 1 sind hier also die Trägergaszuführungen 206.1 und 206.2 direkt in den Schmelztiegel 200 hineingeführt. Über der Oberfläche 224 der Metallschmelze entsteht durch eine längliche Ausführung des Schmelztiegels 200 ein Volumen zur Ausbildung eines vertikalen Gasstroms, angedeutet durch Pfeile 226 und 228. Die weitestgehend geschlossene Ausführung des Schmelztiegels 200 unterstützt die Vermeidung von Vorreaktionen des Stickstoffprecursors (beispielsweise Ammoniak) mit der Metallschmelze. Durch die sich ergebende Limitierung des Gasstroms auf den Durchmesser des Schmelztiegels 200 entsteht eine hohe Strömungsgeschwindigkeit des Trägergasstromes, der einer Eindiffusion des Stickstoffprecursors noch effizienter entgegenwirkt als das in Figur 1 gezeigte Beispiel. Zugleich bewirkt die erhöhte Strömungsgeschwindigkeit einen effizienten Transport des Galliumdampfes in die Reaktorkammer.

Denkbar wäre grundsätzlich auch, allein eine längliche Ausbildung des Schmelztiegels vorzusehen und keine gesonderte Abdeckung nach oben hin vorzusehen. Doch wäre diese Variante nicht so effizient wie die Verringerung des Durchmessers der Austrittsöffnung, wie in Figur 2 gezeigt.

Im Ausführungsbeispiel der Figur 2 sind der Tiegel 200 mit den Trägergaszuführen 206.1 und 206.2 sowie den Leitungen einer Hochfrequenzheizung 204 gezeigt. Bei einer solchen Tiegelkonstruktion ist es vorteilhaft, die oberen Abschnitte der Wandung bei der selben oder einer höheren Temperatur als die Temperatur der Schmelze zu halten. Dies kann beispielsweise durch Verwendung einer Induktionsheizung durch eine entsprechende Gestaltung der Spulen und somit des Hochfrequenzfeldes oder durch eine zusätzliche Widerstandsheizung bewerkstelligt werden.

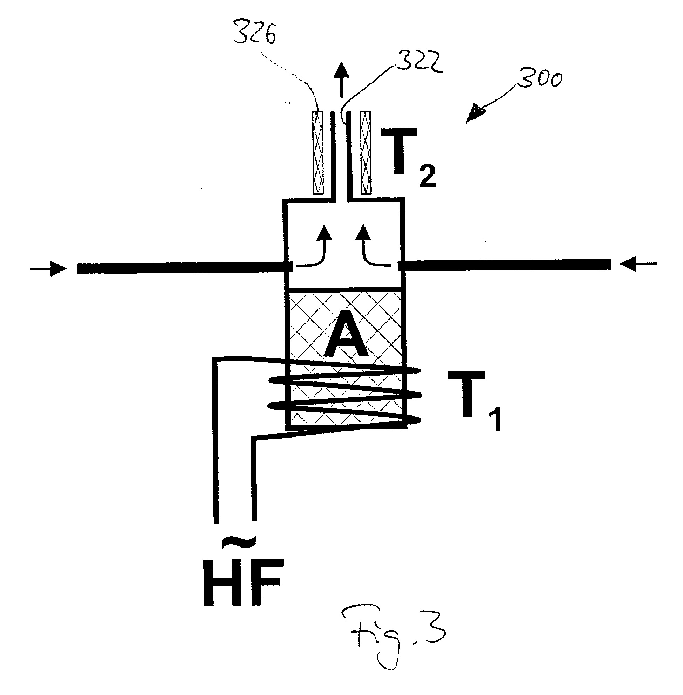

Figur 3 zeigt eine Variante eines Schmelztiegels 300, die eine Umsetzung dieses Gedankens veranschaulicht. Der Schmelztiegel 300 gleicht bis auf die nachfolgend ausgeführten Unterschiede dem Schmelztiegel 200. Anstelle der Öffnung 222 ist ein dünnes Austrittsröhrchen 322 am oberen Ende des Schmelztiegels vorgesehen, durch das der Galliumdampf mit dem Spülgas austritt. Eine Heizung 326 umgibt das Austrittsröhrchen. Zur Vermeidung von Ablagerungen und zur Reduktion der Gefahr einer Gallium-Tröpfchenbildung im Gasstrom sollte die Wandung des Austrittsröhrchens 322 auf eine Temperatur T₂ > T₁ beheizt werden.

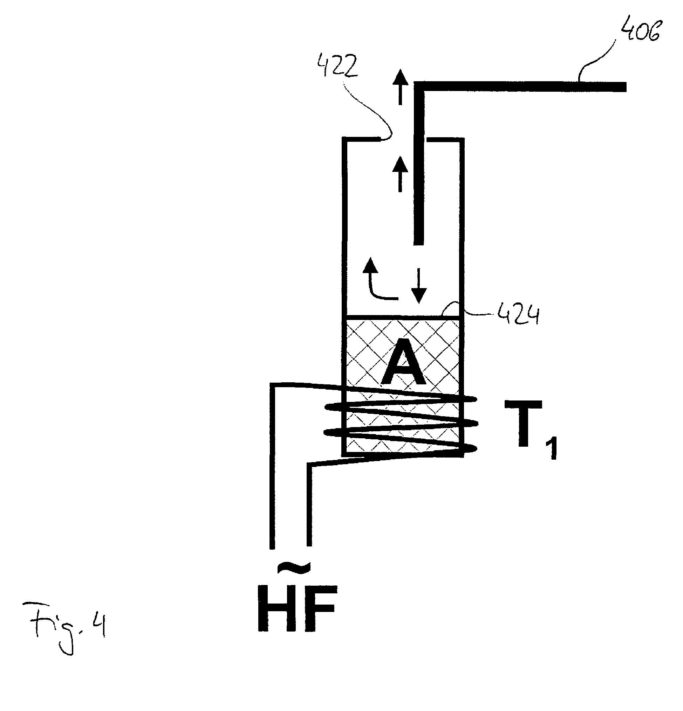

Figur 4 zeigt eine weitere Variante in Form eines Schmelztiegels 400, bei dem eine Zuführung 406 des Trägergases durch eine an der Oberseite des Schmelztiegels vorgesehene Öffnung 422 erfolgt. Der Schmelztiegel gleicht ansonsten dem Schmelztiegel 200 der Figur 2. Auch bei der in Figur 4 dargestellten Trägergaszuführung entsteht ein Gasstrom, der unmittelbar über die Oberfläche 424 der Metallschmelze geleitet wird, dann zusammen mit dem austretenden Galliumdampf nach oben geführt und aus der Austrittsöffnung 422 in Richtung des Reaktionsbereiches geleitet wird. Es ist demnach nicht erforderlich, das Träger- oder Spülgas parallel zur Oberfläche 424 der Metallschmelze einzuleiten, um einen Kontakt der Oberfläche mit dem Stickstoffprecursor zu verhindern. Eine Einleitung senkrecht zur Oberfläche erzielt dieselbe Wirkung.

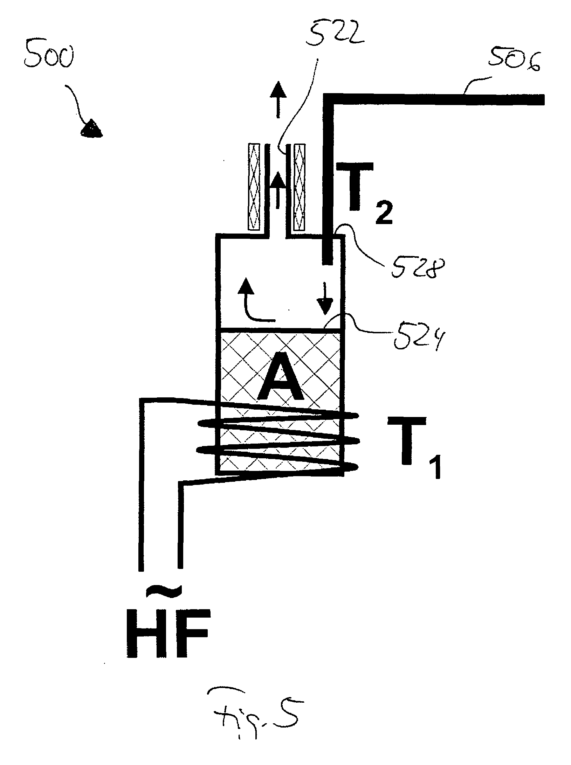

Figur 5 zeigt als weitere Variante einen Schmelztiegel 500, der die Charakteristika der Schmelztiegel 300 und 400 (Vergleiche Figuren 3 und 4) miteinander verbindet. Bei dieser Ausführungsform wird das Trägergas über eine Trägergaszuführung 506 an der Oberseite 528 des Schmelztiegels 500 eingeleitet. Der Gasstrom weist dementsprechend wie im Beispiel der Figur 4 zunächst nach unten, trifft dann auf die Metalloberfläche 524, um von dieser aus mit dem Austretenden Metalldampf zusammen nach oben zu steigen und durch ein Austrittsröhrchen 522 in die Reaktorkammer geleitet zu werden.

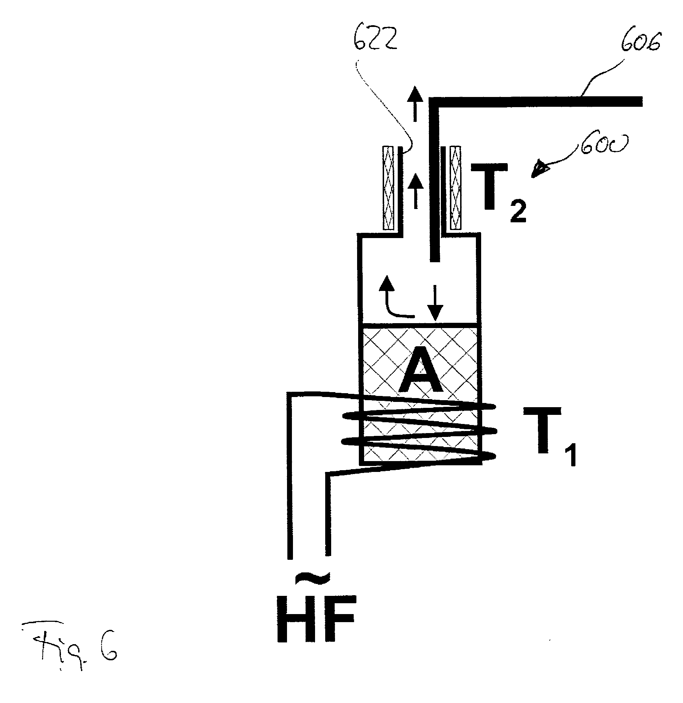

Figur 6 zeigt eine weitere Variante eines Schmelztiegels 600, bei dem das Austrittsröhrchen 622 verbreitert ist, um auch die Trägergaszuführung 606 aufzunehmen.

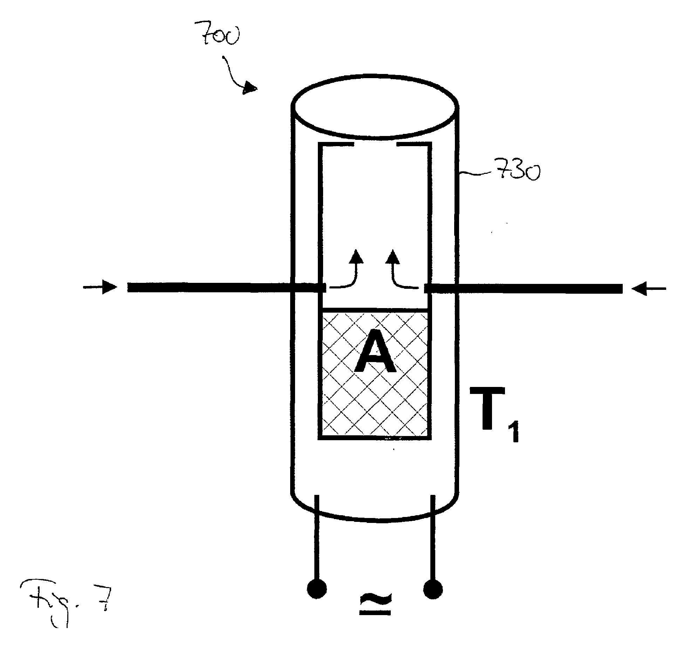

Figur 7 zeigt eine weitere Variante eines Schmelztiegels 700, bei dem anstelle einer Hochfrequenzheizung eine Rohrheizung 730 zum Einsatz kommt. Ansonsten gleicht die Konstruktion des Schmelztiegels der der Figur 2.

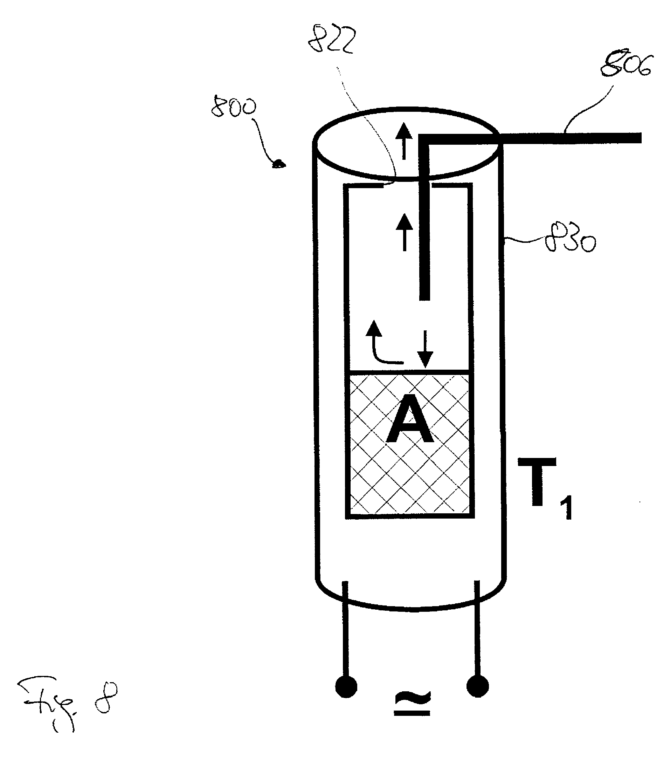

Figur 8 zeigt eine weitere Variante in Form eines Schmelztiegels 800, bei dem, ähnlich wie bei der Ausführungsform der Figur 4 die Trägergaszuführung 806 durch die Austrittsöffnung 822 an der Oberseite des Schmelztiegels geleitet ist. ähnlich wie bei der Ausführungsform der Figur 7 wird eine Rohrheizung 830 verwendet.

Bei den Schmelztiegeln der Figuren 4, 5, 6 und 8 kann die Trägergaszuführung in einer alternativen Ausführungsform in die Metallschmelze hineingeführt werden, so dass das Trägergas in der Metallschmelze blasenförmig aufsteigt und aus der Metallschmelze heraustritt. Diese Ausführungsform ist auch mit den oben beschriebenen kombinierbar, so dass sowohl ein Trägergasfluss auf die Oberfläche der Metallschmelze als auch in sie hinein geleitet wird.

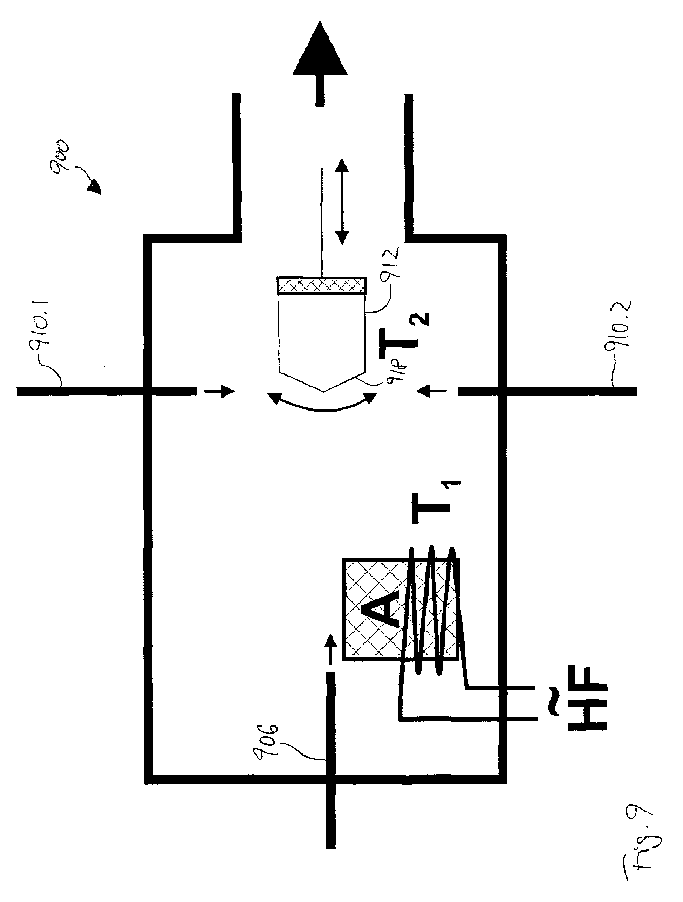

Figur 9 zeigt eine alternative Ausführung einer Reaktorkammer 900. Im Unterschied zur Reaktorkammer 100 der Figur 1 handelt es sich hierbei um eine horizontale Anordnung. Dementsprechend sind der Schmelztiegel A und die Trägergaszuführung 906 angeordnet. Es genügt in diesem Fall auch lediglich auch eine Trägergasleitung, da der horizontale Gasstrom, nachdem er über die Oberfläche der Metallschmelze im Schmelztiegel A geführt wurde, weiter in Richtung des entstehenden Kristalls 912 auf dessen Wachstumsoberfläche 918 hingeführt wird. Bei diesem Ausführungsbeispiel erfolgt die Zuleitung des Precursorgases in vertikaler Richtung durch Precursorzuleitungen 910.1 und 910.2. Im Übrigen ist die Funktionsweise der Reaktoranordnung 900 analog der anhand von Figur 1 beschriebenen Funktionsweise.

Es versteht sich, dass das erfindungsgemäße Verfahren auch zur Herstellung polykristalliner Kristalle verwendet werden kann.

## Patentansprüche

1. Verfahren zur Herstellung eines Galliumnitridkristalls oder eines Aluminiumgalliumnitridkristalls, mit den Schritten:
- Bereitstellen einer Metallschmelze aus reinem Gallium oder aus einer Mischung von Aluminium und Gallium in einem Schmelztiegel;
- Verdampfen von Gallium oder von Gallium und Aluminium aus der Metallschmelze;
- Zerlegen eines Stickstoffprecursors durch thermische Einwirkung oder mittels eines Plasmas;
- Herbeiführen einkristallinen Kristallwachstums eines GaN- oder AIGaN-Kristalls an einem Keimkristall unter einem Druck von weniger als 10 bar;
bei dem
das Verdampfen von Gallium oder von Gallium und Aluminium bei einer Temperatur oberhalb der Temperatur des wachsenden Kristalls, mindestens aber bei 1000 °C durchgeführt wird, und bei dem
ein Gasstrom aus Stickstoffgas, Wasserstoffgas, Inertgas oder einer Kombination dieser Gase über die Metallschmelzenoberfläche geleitet wird, derart, dass der Gasstrom über die Metallschmelzenoberfläche einen Kontakt des Stickstoffprecursors mit der Metallschmelze verhindert.

2. Verfahren nach Anspruch 1, bei dem
die Metallschmelze in einem Schmelztiegelgefäß in einer Reaktorkammer bereitgestellt wird, das, abgesehen von mindestens einer Trägergaszuführung und mindestens einer Trägergasaustrittsöffnung, allseitig geschlossen ist, und bei dem
der Gasstrom durch die Trägergaszuführung oberhalb der Metallschmelze in das Schmelztiegelgefäß eingeleitet und mit Metalldampf der Metallschmelze durch die Trägergasaustrittsöffnung aus dem Schmelztiegelgefäß heraustransportiert wird und
der Stickstoffprecursor in einem Reaktionsbereich in die Reaktorkammer eingeleitet wird.

3. Verfahren nach Anspruch 1, bei dem
das Bereitstellen der Metallschmelze das Anordnen des Schmelztiegels in einer Reaktorkammer umfasst,
der Gasstrom durch eine Trägergaszuführung geringfügig oberhalb der Metallschmelze in die Reaktorkammer eingeleitet wird und
der Stickstoffprecursor in einem Reaktionsbereich in die Reaktorkammer eingeleitet wird.

4. Verfahren nach einem der vorstehenden Ansprüche, bei dem der Gasstrom in einer Richtung parallel zur Oberfläche der Metallschmelze entweder in das Schmelztiegelgefäß oder die Reaktorkammer eingeleitet wird.

5. Verfahren nach einem der vorstehenden Ansprüche, bei dem der Gasstrom in einer Richtung senkrecht zur Oberfläche der Metallschmelze entweder in das Schmelztiegelgefäß oder in die Reaktorkammer eingeleitet wird.

6. Verfahren nach einem der vorstehenden Ansprüche, bei dem das Verdampfen von Gallium oder von Gallium und Aluminium bei einer Temperatur von mindestens 1100 °C durchgeführt wird.

7. Verfahren nach einem der vorstehenden Ansprüche, bei dem ein gasföminger Dotierstoff-Precursor in den Reaktionsbereich eingeleitet wird.

8. Verfahren nach einem der vorstehenden Ansprüche, bei dem ein Dotierstoff in Form einer Schmelze oder eines Feststoffs in der Reaktorkammer bereitgestellt und verdampft bzw. sublimiert wird.

9. Verfahren nach einem der vorstehenden Ansprüche, bei dem der Keimkristall bzw. der wachsende Kristall während des Herbeiführens des einkristallinen Kristallwachstums rotiert.

10. Verfahren nach einem der vorstehenden Ansprüche, bei dem der Gasstrom Wasserstoff enthält oder aus Wasserstoff besteht und das Bereitstellen der Metallschmelze in einem Schmelztiegel das Verwenden eines Schmelztiegels aus Bornitrid BN, Tantal-carbid TaC, Siliziumcarbid SiC, Quarzglas oder Kohlenstoff oder einer Kombination zweier oder mehrerer dieser Materialien umfasst.

11. Reaktoranordnung zur Herstellung eines Galliumnitridkristalls oder eines Galliumaluminiumnitridkristalls, mit
einer Vorrichtung zum Zuführen eines Stickstoffprecursors in einen Reaktionsbereich einer Reaktorkammer,
einer Vorrichtung zum Zerlegen des Stickstoffprecursors im Reaktionsbereich durch thermische Einwirkung oder mittels eines Plasmas,
einem Schmelztiegel zur Aufnahme einer Metallschmelze aus reinem Gallium oder aus einer Mischung von Aluminium und Gallium,
einer ersten Heizvorrichtung, die ausgebildet ist, die Temperatur der Metallschmelze im Schmelztiegel auf einen Wert oberhalb der Temperatur des wachsenden Kristalls, mindestens jedoch 1000 °C einzustellen,
einer Trägergasquelle, die ausgebildet ist, Stickstoffgas, Wasserstoffgas, Inertgas oder eine Kombination dieser Gase abzugeben,
und mit mindestens einer mit der Trägergasquelle verbundenen Trägergaszuführung, die angeordnet und ausgebildet ist, einen Gasstrom über die Metallschmelzenoberfläche zu leiten, derart, dass der Gasstrom einen Kontakt des Stickstoffprecursors mit der Metallschmelze verhindert.

12. Reaktoranordnung nach Anspruch 11, bei der
der Schmelztiegel als Schmelztiegelgefäß ausgebildet ist, das, abgesehen von der Trägergaszuführung und mindestens einer Trägergasaustrittsöff nung, allseitig geschlossen ist, und bei der die Trägergaszuführung oberhalb der Metallschmelzenoberfläche angeordnet ist.

13. Reaktoranordnung nach Anspruch 12, bei der die erste Heizvorrichtung ausgebildet ist, die Wandungen des Schmelztiegelgefäßes oberhalb der Metallschmelze auf einen höhere Temperatur zu heizen als im Bereich Metallschmelze.

14. Reaktoranordnung nach Anspruch 13, bei der die Trägergasaustrittsöffnung das Ende eines rohrförmigen Auslasses bildet, und bei der eine zweite Heizvorrichtung vorgesehen ist, die ausgebildet ist, die Wandungen des Auslasses auf eine höhere Temperatur heizen als die erste Heizvorrichtung die Wandungen des Schmelztiegelgefäßes im Bereich der Metallschmelze.

15. Reaktoranordnung nach einem der Ansprüche 11 bis 14, bei der die Trägergaszuführung ausgebildet ist, einen Gasstrom in einer Richtung parallel zur Oberfläche der Metallschmelze in das Schmelztiegelgefäß oder die Reaktorkammer einzuleiten.

16. Reaktoranordnung nach einem der Ansprüche 11 bis 15, bei der die Reaktorkammer eine Einführöffnung zum Einführen eines Keimkristalls in den Reaktionsbereich hat.

17. Reaktoranordnung nach einem der Ansprüche 11 bis 16, bei der der Schmelztiegel aus Bornitrid BN, Tantalcarbid TaC, Siliziumcarbid SiC, Quarzglas oder Kohlenstoff, oder aus einer Kombination zweier oder mehrerer dieser Materialien gefertigt ist.

18. Reaktoranordnung nach einem der Ansprüche 11 bis 17, mit einer Haltevorrichtung für den Keimkristall, die ausgebildet ist, den Keimkristall während des Kristallwachstums zu rotieren.

19. Reaktoranordnung nach einem der Ansprüche 11 bis 18, mit einem zweiten Schmelztiegel, der zur Aufnahme einer Aluminiumschmelze ausgebildet ist.

## Claims

1. A process for producing a gallium nitride crystal or an aluminium gallium nitride crystal, comprising the steps:
- providing a metal melt of pure gallium or of a mixture of aluminium and gallium in a crucible;
- vaporising gallium, or gallium and aluminium, from the metal melt;
- decomposing a nitrogen precursor by thermal action or by means of a plasma;
- inducing monocrystalline growth of a GaN or AlGaN crystal on a seed crystal under a pressure of less than 10 bar;
in which
the vaporisation of gallium, or of gallium and aluminium, is carried out at a temperature above the temperature of the growing crystal, but at 1000 °C at least, and in which
a gas stream of nitrogen gas, hydrogen gas, inert gas or a combination of said gases is guided over the surface of the metal melt in such a way that the gas stream over the surface of the metal melt prevents the nitrogen precursor from contacting the metal melt.

2. A process according to claim 1, in which the metal melt is provided in a crucible container inside a reactor chamber which is closed on all sides, except for at least one carrier gas feed and at least one carrier gas exit port, and in which
the gas stream is introduced into the crucible container through the carrier gas feed line above the metal melt and is transported with vapourised metal from the metal melt through the carrier gas exit port out of the crucible container, and
the nitrogen precursor is introduced into the reactor chamber in a reaction region.

3. A process according to claim 1, in which
providing the metal melt includes arranging the crucible in a reactor chamber,
the gas stream is introduced into the reactor chamber through a carrier gas feed line slightly above the metal melt and
the nitrogen precursor is introduced into the reactor chamber in a reaction region.

4. A process according to any one of the preceding claims, in which the gas stream is introduced either into the crucible container or into the reactor chamber in a direction parallel to the surface of the metal melt.

5. A process according to any one of the preceding claims, in which the gas stream is introduced either into the crucible container or into the reactor chamber in a direction perpendicular to the surface of the metal melt.

6. A process according to any one of the preceding claims, in which vapourisation of gallium, or of gallium and aluminium, is carried out at a temperature of at least 1100 °C.

7. A process according to any one of the preceding claims, in which a gaseous dopant precursor is introduced into the reaction region.

8. A process according to any one of the preceding claims, in which a doping substance is provided in the form of a melt or a solid in the reactor chamber and is vapourised or sublimated.

9. A process according to any one of the preceding claims, in which the seed crystal or the growing crystal rotates while monocrystalline crystal growth is induced.

10. A process according to any one of the preceding claims, in which the gas stream contains hydrogen or consists of hydrogen, and providing the metal melt in a crucible includes using a crucible made of boron nitride BN, tantalum carbide TaC, silicon carbide SiC, quartz glass or carbon, or of a combination of two or more of said materials.

11. A reactor arrangement for producing a gallium nitride crystal or an aluminium gallium nitride crystal, comprising
a device for feeding a nitrogen precursor into a reaction region of a reactor chamber,
a device for decomposing the nitrogen precursor in the reaction region by thermal action or by means of a plasma,
a crucible for receiving a metal melt of pure gallium or of a mixture of aluminium and gallium;
a first heating device adapted to set the temperature of the metal melt in the crucible to a value above the temperature of the growing crystal, but to at least 1000 °C,
a carrier gas source adapted to deliver nitrogen gas, hydrogen gas, inert gas or a combination of said gases,
and further comprising at least one carrier gas feed connected to the carrier gas source, said carrier gas feed being disposed and adapted to conduct a gas stream over the surface of the metal melt in such a way that the gas stream prevents the nitrogen precursor from contacting the metal melt.

12. A reactor arrangement according to claim 11, in which
the crucible is designed as a crucible container which is closed on all sides, except for at least one carrier gas feed and at least one carrier gas exit port, and in which the carrier gas feed is disposed above the surface of the metal melt.

13. A reactor arrangement according to claim 12, in which the first heating device is adapted to heat the walls of the crucible container above the metal melt to a temperature which is higher than the temperature in the region of the metal melt.

14. A reactor arrangement according to claim 13, in which the carrier gas exit port forms the end of a tubular outlet, and in which a second heating device is provided which is adapted to heat the walls of the outlet to a temperature which is higher than the temperature to which the first heating device heats the walls of the crucible container in the region of the metal melt.

15. A reactor arrangement according to any one of claims 11 to 14, in which the carrier gas feed is adapted to introduce a gas stream into the crucible container or into the reactor chamber in a direction parallel to the surface of the metal melt.

16. A reactor arrangement according to any one of claims 11 to 15, in which the reactor chamber has an insertion opening for introducing a seed crystal into the reaction region.

17. A reactor arrangement according to any one of claims 11 to 16, in which the crucible is made of boron nitride BN, tantalum carbide TaC, silicon carbide SiC, quartz glass or carbon, or of a combination of two or more of said materials.

18. A reactor arrangement according to any one of claims 11 to 17, comprising a holding device for the seed crystal, said device being adapted to rotate the seed crystal during crystal growth.

19. A reactor arrangement according to any one of claims 11 to 18, comprising a second crucible which is adapted to receive an aluminium melt.

## Revendications

1. Procédé de production d'un cristal de nitrure de gallium ou d'un cristal de nitrure d'aluminium et de gallium, comprenant les stades :
- on met un métal fondu composé de gallium pur ou d'un mélange d'aluminium et de gallium dans un creuset de fusion ;
- on évapore du gallium ou du gallium et de l'aluminium du métal fondu ;
- on décompose un précurseur d'azote par effet thermique ou au moyen d'un plasma ;
- on provoque une croissance monocristalline d'un cristal de GaN ou d'AlGaN sur un cristal germe sous une pression de moins de 10 bar ;
dans lequel
on effectue l'évaporation de gallium ou de gallium et d'aluminium à une température supérieure à la température du cristal en croissance mais au moins à 1 000°C, et dans lequel
on envoie un courant gazeux composé d'azote gazeux, d'hydrogène gazeux, de gaz inerte ou d'une association de ces gaz à la surface du métal fondu, de manière à ce que le courant gazeux à la surface du métal fondu empêche un contact du précurseur d'azote avec le métal fondu.

2. Procédé suivant la revendication 1, dans lequel on met le métal fondu dans un récipient formant creuset de fusion dans une chambre formant réacteur, qui, indépendamment d'au moins une arrivée de gaz porteur et d'au moins une ouverture de sortie du gaz porteur, est fermée de tous côtés, et dans lequel
on envoie le courant gazeux par l'arrivée de gaz porteur au-dessus du métal fondu dans le récipient formant creuset de fusion et on le fait sortir avec de la vapeur métallique du métal fondu du récipient formant creuset de fusion par l'ouverture de sortie du gaz porteur et
on envoie le précurseur d'azote dans une partie de réaction de la chambre formant réacteur.

3. Procédé suivant la revendication 1, dans lequel mettre le métal fondu comprend mettre le creuset de fusion dans une chambre formant réacteur,
on envoie le courant gazeux dans la chambre formant réacteur par une arrivée de gaz porteur légèrement au-dessus du métal fondu et
on envoie le précurseur d'azote dans une partie de réaction de la chambre formant réacteur.

4. Procédé suivant l'une des revendication précédentes, dans lequel on envoie le courant gazeux dans une direction parallèle à la surface du métal fondu dans le récipient formant creuset de fusion ou dans la chambre formant réacteur.

5. Procédé suivant l'une des revendication précédentes, dans lequel on envoie le courant gazeux dans une direction perpendiculaire à la surface du métal fondu dans le récipient formant creuset de fusion ou dans la chambre formant réacteur.

6. Procédé suivant l'une des revendication précédentes, dans lequel on effectue l'évaporation de gallium ou de gallium et d'aluminium à une température d'au moins 1 100°C.

7. Procédé suivant l'une des revendication précédentes, dans lequel on envoie un précurseur gazeux de substance de dopage dans la partie de réaction.

8. Procédé suivant l'une des revendication précédentes, dans lequel on met une substance de dopage sous la forme d'une masse fondue ou d'une matière solide dans la chambre formant réacteur et on l'évapore ou on la sublime.

9. Procédé suivant l'une des revendication précédentes, dans lequel on fait tourner le cristal germe ou le cristal en croissance pendant que l'on provoque la croissance de cristal monocristalline.

10. Procédé suivant l'une des revendications précédentes, dans lequel le courant gazeux contient de l'hydrogène ou est constitué d'hydrogène et mettre le métal fondu dans un creuset de fusion comprend l'utilisation d'un creuset de fusion en nitrure de bore BN, en carbure de tantale TAC, en carbure de silicium SiC, en verre au quartz ou en carbone ou une association de deux ou plusieurs de ces matières.

11. Réacteur de production d'un cristal de nitrure de gallium ou d'un cristal de nitrure de gallium et d'aluminium, comprenant
un dispositif pour apporter un précurseur d'azote dans une partie de réaction d'une chambre formant réacteur,
un dispositif de décomposition du précurseur d'azote dans la partie de réaction par effet thermique ou au moyen d'un plasma,
un creuset de fusion pour la réception d'un métal fondu composé de gallium pur ou d'un mélange d'aluminium et de gallium,
un premier dispositif de chauffage qui est constitué pour porter la température du métal fondu dans le creuset de fusion à une valeur supérieure à la température du cristal en croissance, toutefois d'au moins 1 000°C,
une source de gaz porteur qui est constituée pour céder de l'azote gazeux, de l'hydrogène gazeux, un gaz inerte ou une association de ces gaz,
et comprenant au moins une arrivée de gaz porteur qui communique avec la source de gaz porteur et qui est disposée et constituée pour envoyer un courant gazeux à la surface du métal fondu, de manière à ce que le courant gazeux empêche un contact du précurseur d'azote avec le métal fondu.

12. Réacteur suivant la revendication 11, dans lequel le creuset de fusion est constitué en récipient formant creuset de fusion, qui, indépendamment de l'arrivée de gaz porteur et d'au moins une ouverture de sortie du gaz porteur, est fermé de tous côtés et dans lequel l' arrivée de gaz porteur est disposée au-dessus de la surface du métal fondu.

13. Réacteur suivant la revendication 12, dans lequel le premier dispositif de chauffage est constitué pour chauffer les parois du récipient formant creuset de fusion au-dessus du métal fondu jusqu'à une température plus haute que dans la zone du métal fondu.

14. Réacteur suivant la revendication 13, dans lequel l'ouverture de sortie du gaz porteur forme l'extrémité d'une sortie tubulaire et dans lequel il est prévu un deuxième dispositif de chauffage, qui est constitué pour chauffer les parois de la sortie jusqu'à une température plus haute que celle à laquelle le premier dispositif de chauffage chauffe les parois du récipient formant creuset de fusion dans la zone du métal fondu.

15. Réacteur suivant l'une des revendications 11 à 14, dans lequel l'arrivée de gaz porteur est constituée pour envoyer un courant gazeux dans une direction parallèle à la surface du métal fondu dans le récipient formant creuset de fusion ou dans la chambre formant réacteur.

16. Réacteur suivant l'une des revendications 11 à 15, dans lequel la chambre formant réacteur a une ouverture d'introduction pour l'introduction d'un cristal germe dans la partie de réaction.

17. Réacteur suivant l'une des revendications 11 à 16, dans lequel le creuset de fusion est en nitrure de bore BN, en carbure de tantale TAC, en carbure de silicium SiC, en verre au quartz ou en carbone ou une association de deux ou plusieurs de ces matières.

18. Réacteur suivant l'une des revendications 11 à 17, comprenant un dispositif de support du cristal germe qui est constitué pour faire tourner le cristal germe pendant la croissance du cristal.

19. Réacteur suivant l'une des revendications 11 à 18, comprenant un deuxième creuset de fusion qui est constitué pour la réception d'aluminium fondu.
